(19) Europäisches Patentamt

European Patent Office

Office européen des brevets

(11) **EP 1 612 898 B1**

(12) **EUROPEAN PATENT SPECIFICATION**

(45) Date of publication and mention
of the grant of the patent:
**29.08.2007 Bulletin 2007/35**

(51) Int Cl.:
*H01T 4/08* (2006.01)          *H01L 23/60* (2006.01)

(21) Application number: **04015413.0**

(22) Date of filing: **30.06.2004**

(54) **Spark gap apparatus and method for electrostatic discharge protection**

Funkenstreckevorrichtung und Verfahren zum elektrostatischen Entladungsschutz

Dispositif éclateur et méthode de protection contre les décharges électrostatiques

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(43) Date of publication of application:
**04.01.2006 Bulletin 2006/01**

(73) Proprietor: **Research In Motion Limited Waterloo, Ontario N2L 3W8 (CA)**

(72) Inventors:
• **Cheung, Tim O.**
**Santa Barbara, CA 93111 (US)**
• **Fregin, Douglas Edgar**
**Waterloo, Ontario N2L 1W7 (CA)**

(74) Representative: **Schmit Chretien Schihin & Mahler Baaderstraße 3 80469 München (DE)**

(56) References cited:
**EP-A- 0 610 898          EP-A- 1 229 618**
**US-A1- 2003 075 532      US-B1- 6 241 537**

• **GILMORE P ET AL: "A COMPONENTLASS, ELECTROSTATIC DISCHARGE TECHNIQUE" MOTOROLA TECHNICAL DEVELOPMENTS, MOTOROLA INC. SCHAUMBURG, ILLINOIS, US, vol. 20, 1 October 1993 (1993-10-01), page 135, XP000403852 ISSN: 0887-5286**

## Description

This disclosure generally relates to electrostatic discharge (ESD) protection devices, methods of manufacturing ESD protection devices, and electronic devices incorporating spark gap ESD protection devices.

Spark gaps are ESD protection devices that comprise two or more spaced apart electrodes having a breakdown voltage dependent on the electrode spacing and geometry. When a voltage across the gap spacing exceeds the breakdown voltage, an arc is created across the spark gap that causes the voltage across the spark gap to clamp to a clamp level.

This disclosure describes a novel spark gap fabrication method according to claim 1 and a novel spark gap device according to claim 10. This disclosure also describes novel applications of conventional spark gap devices and novel applications of the novel spark gap devices described herein.

US 2003/0075532 A1 discloses a method of forming conductive tracks on a substrate using a laser ablation technique in order to produce Printed Circuit Boards (PCBs). The method involves the initial step of coating a substrate such as alumina substrate with a conductive ink to create a conductive ink layer. Subsequent to this, a laser spot is focussed onto the ink in order to ablate a portion of the ink layer from the substrate to define tracks of ink, which are then cured. Also disclosed is a method of forming multiple layers of conductive tracks on a substrate, each layer of conductive tracks being separated by a layer of cured dielectric ink.

The document "A Componentless, Electrostatic Discharge Technique", P. Gilmore et al., Motorola Technical Developments, Motorola Inc., Schaumburg, Illinois, US, Vol. 20, 1 October 1993, page 135, discloses a configuration on a flexible or rigid printed circuit that provides a preferred path for the high energy of an electrostatic charge, to discharge. As the charge builds up on a first circuit trace it is most likely to arc from the probe of the first circuit trace to the adjacent probe of a second circuit trace which could carry the charge to ground.

EP 0610 898 A1 which is considered to represent the closest prior art, discloses an overvoltage protection device, and a method of manufacturing it, comprising a first AC pattern having first and second concave circular arc sections and a first peak point, a second AC pattern having third and fourth concave circular arc sections and a second peak point, and a frame ground pattern having a fifth concave circular arc section with the first peak point as a center and a sixth concave circular arc section with the second peak point as a center. Both ends of the fifth concave circular arc section are located at centers of the first and second concave circular arc sections, and both ends of the sixth concave circular arc section are located at centers of the third and fourth concave circular arc sections. If an overvoltage is applied to any of the first and second AC patterns, a discharge occurs across any of the AC pattern and the frame ground pattern.

DRAWINGS

Fig. 1 depicts a plurality of laser footprints in overlapping disposition on a conductor surface;

Fig. 2 is a flowchart for a method of fabricating a circumferential extension spark gap device;

Figs. 3 and 4 depict example embodiments of a circumferential extension spark gap device;

Fig. 5 depicts a plurality of laser footprints in both vertical and horizontal overlapping disposition on a conductor surface;

Fig. 6 is an example embodiment of a circumferential extension spark gap device formed by the laser footprint pattern of Fig. 5;

Fig. 7 depicts another embodiment of a circumferential extension spark gap device;

Fig. 8 depicts another embodiment of a spark gap device including a shunt capacitor;

Fig. 9 depicts a side view of a first printed circuit board embodiment of the spark gap device of Fig. 8;

Fig. 10 depicts a side view of a second printed circuit board embodiment of the spark gap device of Fig. 8;

Fig. 11 depicts a side view of a third printed circuit board embodiment of the spark gap device of Fig. 8;

Fig. 12 depicts another embodiment of a circumferential extension spark gap device;

Figs. 13 and 14 depict side and top views of a spark gap device in a flex circuit;

Fig. 15 depicts example embodiments of spark gap devices integrated into surface mount components;

Fig. 16 depicts an example embodiment of a spark gap device in a surface mount capacitor;

Fig. 17 provides a plurality of circuit representations for various surface mount components having integrated spark gap devices;

Fig. 18 depicts a top view of a mobile communication device;

Fig. 19 depicts a spark gap device for providing ESD protection from a metal surface case component of the mobile communication device;

Figs. 20 and 21 depict side and bottom views of one embodiment of a spark gap device for providing ESD protection from a metal surface case component of the mobile communication device;

Figs. 22 and 23 depict side and bottom views of another embodiment of a spark gap device for providing ESD protection from a metal surface case component of the mobile communication device;

Fig. 24 is an example printed circuit board (PCB) having integrated circumferential extension spark gap devices for providing ESD protection; and

Fig. 25 is an example subscriber identity module (SIM) card having integrated circumferential extension spark gap devices for providing ESD protection.

DETAILED DESCRIPTION

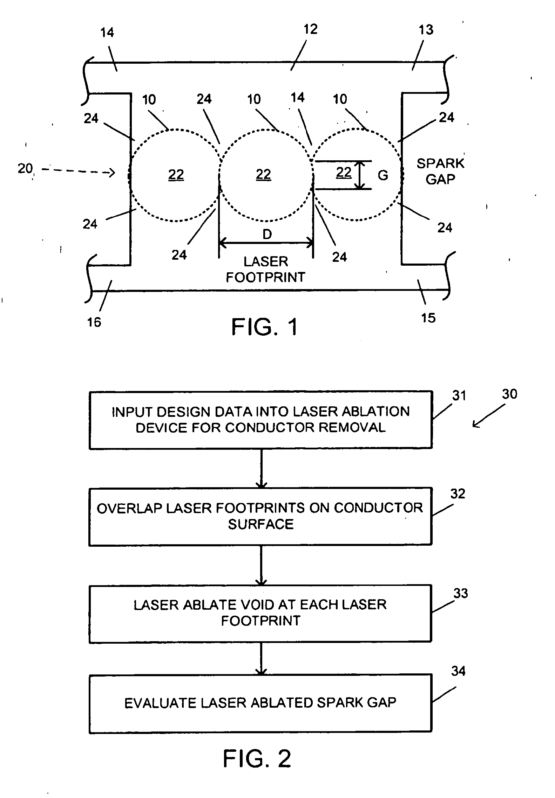

Fig. 1 depicts a plurality of laser footprints 10 in overlapping disposition on a conductor surface 12. The conductor surface 12 is typically a conductive trace material, such as copper, gold, or the like, that is deposited on a substrate material or integrated into a thin film interconnect layer. Conductive traces 13, 14, 15 and 16 are used to electrically connect electronic circuit elements or to define conductive electrical paths. For example, conductive trace 13 may be connected to signal processing circuitry and conductive trace 14 may be connected to an input pin on a Universal Serial Bus (USB) port, while conductive traces 15 and 16 may be connected to a reference ground.

The laser footprints 10 each have a diameter D within which the conductor surface 12 is etched away when a laser is activated. As the conductor surface 12 is ablated away in each footprint 10, a spark gap 20 is formed. The conductor surface 12 is removed by laser ablation, which results in overlapping arcuate voids 22 in the conductor surface 12 that coincide with the laser footprints 10. A plurality of remaining conductive circumferential extensions 24 define the overlapping arcuate voids 24. The distance G between the tips of the circumferential extensions 24 is the spark gap distance. Typically, the laser ablation will remove to a particular depth the substrate material on which conductive surface is deposited.

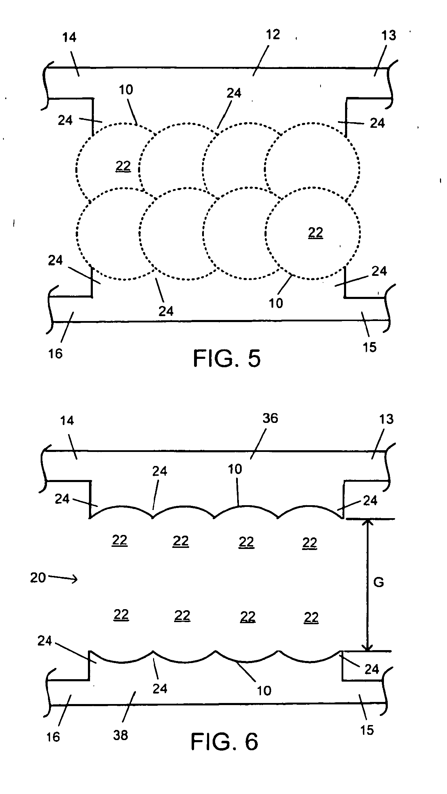

Fig. 2 is a flowchart 30 for a method of fabricating a circumferential extension spark gap device 20. In step 31, design data is input into a laser ablation device for conductor removal. The design data may comprise data used by a laser ablation device to selectively position and activate a laser used in steps 32 and 33. In step 32, laser footprints are overlapped on a conductor surface. The laser footprints may be overlapped simultaneously, such as when utilizing multiple lasers, or may be overlapped sequentially, such as when using a single laser and redirecting the laser beam relative to the conductor surface. The laser footprints may also be overlapped only in a horizontal direction as shown in Fig. 1, or may be overlapped in both a vertical and horizontal direction, as shown in Fig. 5.

In step 33, a void is laser ablated at each laser footprint. Laser ablation will remove the conductor surface within the laser footprint. After all of the voids in the conductor surface have been created, the resulting conductor surface is separated into two conductive regions separated by a circumferential extension spark gap 20.

In step 34, the laser-ablated spark gap is evaluated. The evaluation may comprise electrical testing, visual inspection, of a combination of both electrical testing and visual inspection.

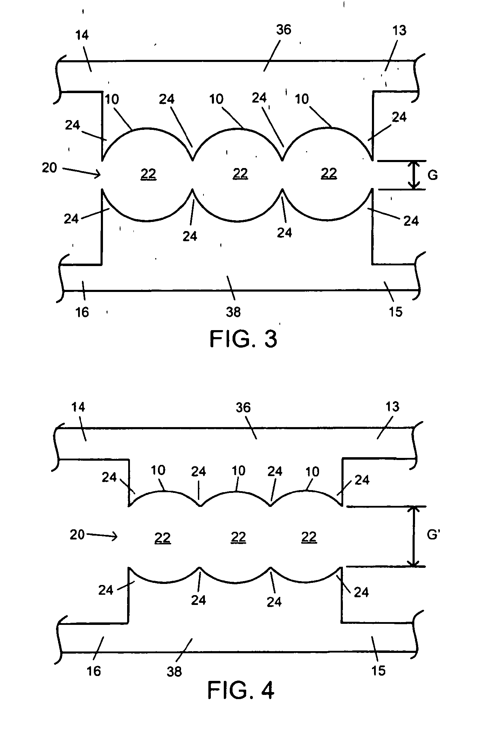

Figs. 3 and 4 depict example embodiments of a circumferential extension spark gap device 20. Each spark gap 20 comprises a plurality of circumferential extensions 24 that define arcuate voids 22. The arcuate voids 22 in the conductive material separate a first conductor 36 and a second conductor 38. The circumferential extensions 24 on the first conductor 36 are in opposing disposition to the circumferential extensions 24 on the second conductor 38. Conductive traces 13 and 14 of the first conductor 36 are used to electrically connect electronic circuit elements or to define conductive electrical paths. Conductive traces 15 and 16 of the second conductor 38 are used to connect the second conductor to a reference potential, such as a ground.

The spark gap distance may be adjusted by adjusting the amount of overlap in the laser footprints. For example, the overlap amount of the laser footprints in Fig. 3 is less than the overlap amount of the laser footprints in Fig. 4. Accordingly, the spark gap distance G of Fig. 3 is less than the spark gap distance G' of Fig. 4. In one embodiment, the overlap amount of the laser footprints is adjusted to obtain a spark gap distance G of approximately 12 $\mu$m. In this embodiment, the laser footprints are horizontally overlapped as in Fig. 4, and thus the spark gap distance G is less than the diameter of the laser footprint.

In another embodiment, the laser footprints may be both vertically and horizontally overlapped to adjust the spark gap distance G. Fig. 5 depicts a plurality of laser footprints 22 in both vertical and horizontal overlapping disposition on a conductor surface. Fig. 6 is an example embodiment of a circumferential extension spark gap device 20 formed by the laser footprint pattern of Fig. 5. The circumferential extensions 24 define the arcuate voids 22 for each overlapping laser footprint. Thus, by vertically and horizontally overlapping the laser footprints, the spark gap distance G may be adjusted to a distance greater than the diameter of the laser beam footprint.

While only three void regions 22 are shown in Figs. 3 and 4, the spark gap 20 may comprise circumferential extensions defining tens, hundreds or even thousands of voids 22. Increasing the number of circumferential extensions tends to increase the durability of the spark gap to repeated use. Additionally, while the laser footprints 10 and/or resultant arcuate voids 22 are depicted as circular, the laser footprints 10 and/or resultant arcuate voids 22 may also comprise other arcuate shapes, depending on the particular laser device implemented.

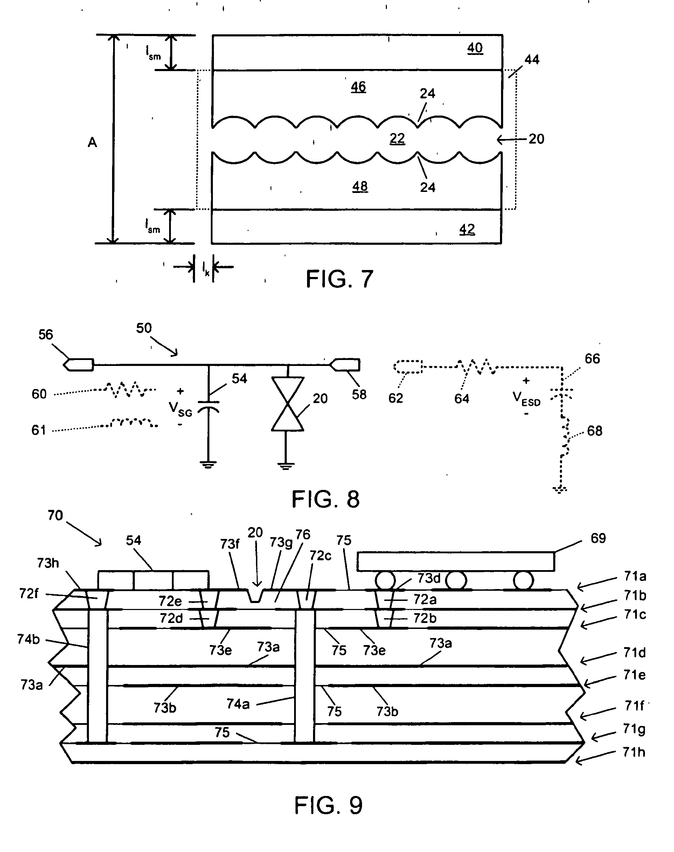

Fig. 7 depicts another embodiment of a circumferential extension spark gap device 20. The spark gap device 20 of Fig. 7 is an embodiment that may be used in a printed circuit board (PCB) or a flex circuit. Conductive surfaces 46 and 48 are covered by solder masks 40 and 42, respectively. A spark gap 20 comprising a plurality of circumferential extensions 24 that define arcuate voids 22 separates the conductive surfaces 46 and 48. A keep-out zone 44 separates the spark gap 20 from adjacent pads. In one embodiment, the solder masks 40 and 42 lengths $l_{sm}$, and the keep out zone 44 length $l_k$ are 0.1mm, and the surface area of the spark gap device

A is 0.5mm$^2$.

Fig. 8 depicts another embodiment 50 of a spark gap device 20 including a shunt capacitor 54 that is connected in parallel with the spark gap device 20. An ESD sensitive device, such as digital processing circuitry, may be connected to a connection point 56. The connection point 58 defines an ESD entry point, such as a signal line in a USB port. The connection point 62 defines an ESD source, such as a person or an electrical device that may have a different potential than the potential of connection point 58. The ESD energy may be modeled as an energy discharge from a RLC circuit comprising a series connected resistor 64, capacitor 66, and inductor 68.

The shunt capacitor 54 provides additional shunt protection and voltage limiting. The voltage across the spark gap is approximated by the equation:

$$V_{SG} = V_{ESD}(C_{ESD}/(C_{SG} + C_{ESD}))$$

where

$V_{ESD}$ is the voltage across the capacitor 66;
$C_{ESD}$ is the capacitance of capacitor 66; and
$C_{SG}$ is the capacitance of the capacitor 54.

In one embodiment, an optional resistor 60 may be connected in series with the parallel connected spark gap 20 and capacitor 54 to further limit the injection of ESD energy into the ESD sensitive device. Additionally, the resulting reactive network acts as a single-pole filter. In another embodiment, an optional inductor 61 may be connected in series with the parallel connected spark gap 20 and capacitor 54 to further limit the injection of ESD energy into the ESD sensitive device.

Fig. 9 depicts a side view of a first printed circuit board 70 embodiment of the spark gap device 50 of Fig. 8. The printed circuit board 70 comprises a plurality of levels 71a-h. In particular, levels 71 a, 71 b, 71 c, 7 1 f, 71 g and 71 h comprises signal levels upon which conductive signal traces are deposited. Level 71 d comprises a ground level upon which a conductive ground trace is deposited. Level 71e comprises a power level upon which a conductive power trace is deposited. The conductive signal traces of levels 71 a, 71b, 71c, 71f, 71 g and 71h are used to conduct electrical data signals. The ground trace of level 71d may be connected to a ground reference potential, such as a $V_{ss}$ potential, and the conductive power trace of level 71e may connected to a power potential, such as a $V_{cc}$ potential.

Conductive traces on each level 71a-h are depicted by their thickened side profiles 73 relative to surfaces 75 that represent the demarcation between printed circuit board levels. For example, the conductive trace 73a that is deposited on ground level 71d may comprise a ground trace or a ground plane. The conductive trace 73a is also connected to ground vias 74a and 74b to provide access to the ground potential in other layers of the printed circuit board. Each ground via 74a and 74b comprises a conductive trace deposited on the interior surface of the via, or may comprise a conductive core filling the interior region of the via. The conductive trace 73b on power level 71f is not connected to the ground vias 74a and 74b, as represented by the surface area 75 interposed between the conductive trace 73b and ground vias 74a and 74b. Likewise, the conductive trace 73e on signal level 71c is not connected to the ground via 74a, as represented by the surface area 75 interposed between the conductive trace 73e and ground via 74a.

Conductive trace interconnections between levels 71 may also be established by conductive vias 72. Each conductive via 72 comprises a conductive trace deposited on the interior surface of the via, or may comprise a conductive core filling the interior region of the via. For example, in the cross section shown, conductive trace 73d is connected to conductive trace 73e through conductive vias 72a and 72b. Likewise, the conductive trace 73e is connected to conductive trace 73f through conductive vias 72e and 72d; conductive trace 73g is connected to ground via 74a by conductive via 72c; and conductive trace 73h is connected to ground via 74b through conductive via 72f.

Atop signal layer 71a are a surface mount capacitor 54 and a ball grid array (BGA) mounted electrical device 69. Other mounting methods other than those shown may also be used. The electrical device 69 may comprise any electrical device having or requiring ESD protection, such as a discrete electrical component, an integrated circuit, and the like.

A circumferential spark gap 20, which comprises conductive traces 73f and 73g, is interposed between one terminal of the capacitor 54 and ground via 74a. The spark gap 20 is formed by the laser ablation process described above. The laser ablation typically removes a particular depth of the substrate material upon which the conductive material is deposited, as indicated in the slightly conical depression in the dielectric 76 beneath the spark gap 20.

Conductive trace 73g of the spark gap 20 is connected to the ground via 74a through conductive via 72c. The other conductive trace 73f of the spark gap 20 is connected to one terminal of the capacitor 54 through conductive vias 72d and 72e, and also to conductive trace 73e. The conductive trace 73e, in turn, is connected to the electronic device 69 through conductive vias 72a and 72b and conductive trace 73d. Additionally, the other end of the capacitor 54 is connected to the ground via 74b through conductive trace 72f. Thus, the capacitor 54 and the spark gap 20 are interposed in parallel between the electrical device 69 and ground to provide spark gap ESD protection with a parallel shunt capacitance.

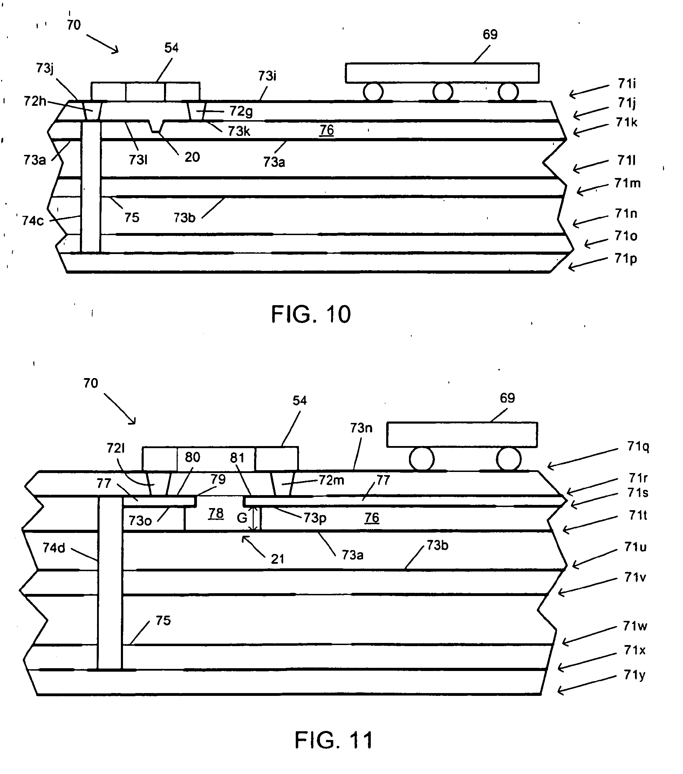

Fig. 10 depicts a side view of a second printed circuit board 70 embodiment of the spark gap device of Fig. 8. The printed circuit board 70 of Fig. 10 comprises signal levels 71i, 71j, 71 n, 71o and 71p, ground levels

71k and 71l, and power level 71 m. This embodiment is similar to the embodiment of Fig. 9, except that the circumferential spark gap is fabricated in a layer beneath the top layer 71 i.

Fig. 11 depicts a side view of a third printed circuit board 70 embodiment of the spark gap device of Fig. 8. The printed circuit board 70 of Fig. 11 comprises signal levels 71q, 71r, 71s, 71v, 71w and 71x, ground levels 71t and power level 71u. Signal level 71r further comprises a thin laminate 77 upon which one or more conductive traces may be deposited. The thin laminate 77 is used to form a spark gap 21. The laminate 77 includes a periphery 79 that defines an opening. The opening is placed over a space 78 in the dielectric 76 and extends over the periphery defined by the space 78. In the embodiment shown in Fig. 11, the geometry of the opening in the laminate 77 is such that the laminate 77 extends over the sides of the dielectric space 78.

A first side 80 of the opening comprises a conductive trace and is connected to a ground via 74d and a first terminal of the capacitor 54 through conductive via 72l. A second side 81 of the opening likewise comprises a conductive trace and is connected to a conductive via 72m. The conductive via 72m is, in turn, connected to the other terminal of the capacitor 54 and the electronic device 69 by conductive trace 73n. Spark gap protection is thus provided by the gap formed by the conductive trace 73p on the second side 81 of the opening and the conductive ground trace 73a. Thus, the capacitor 54 and the spark gap 21 are interposed in parallel between the electrical device 69 and ground to provide spark gap ESD protection.

A shunt capacitor may also be fabricated directly in the printed circuit board 70. For example, in Fig. 11, the dielectric 76 interposed between the laminate 77 and the conductive ground trace 73a may be selected so that the dielectric 76 and the conductive traces 73a and 73p form a capacitor. Accordingly, a first terminal of the capacitor is connected to the electrical device 69 through the conductive via 72m and conductive trace 73n. The second terminal of the capacitor comprises the conductive ground trace 73a, and thus the capacitor 54 and the spark gap 21 are interposed in parallel between the electrical device 69 and ground to provide spark gap ESD protection.

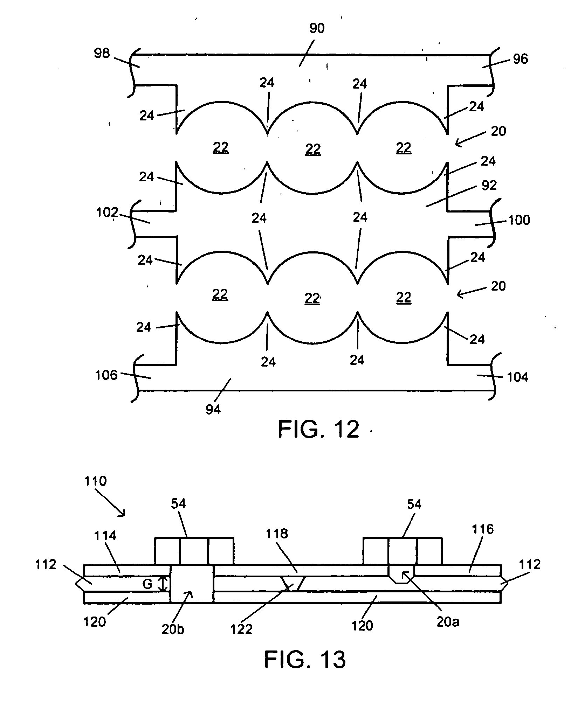

Fig. 12 depicts another embodiment of a circumferential extension spark gap device 20. In this embodiment, conductor 90 and conductive traces 96 and 98 comprise a first signal path, and conductor 94 and conductive traces 104 and 106 comprise a second signal path. Conductive traces 100 and 102 are connected to a ground reference so that conductor 92 provides a spark gap ground reference. Each spark gap 20 is similar to the spark gaps described with respect to Figs. 1 - 6 above, and comprises a plurality of conductive circumferential extensions 24 that define voids 22 in the conductive surface.

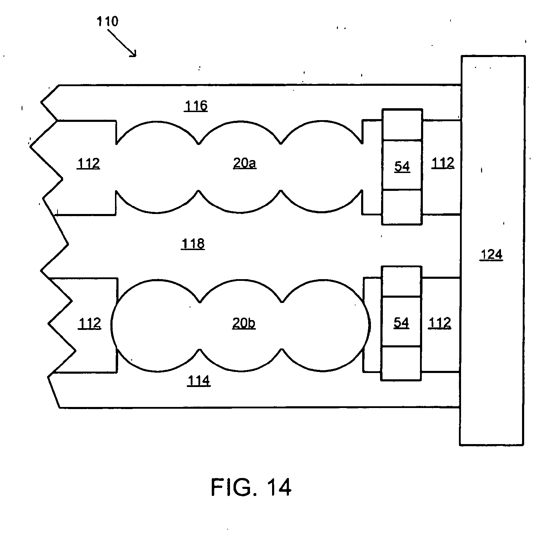

Figs. 13 and 14 depict side and top views, respectively, of a spark gap device in a portion of a flex circuit 110. The flex circuit 110 comprises a flexible dielectric or insulating material 112. In one embodiment, the flexible material comprises a polyimide material. Other flexible materials may also be used, such as a liquid crystal polymer (LCP) material. In another embodiment, the dielectric 112 may be selected so that the dielectric constant and the conductive traces between which the dielectric is interposed form a capacitor.

Conductive traces 114, 116 and 118 are positioned near the top layer of the flex circuit 110. A bottom conductive trace comprises a conductive ground trace 120. The conductive trace 118 is connected to the conductive ground trace 120 through a conductive via 122. Conductive traces 114 and 116 may be connected to signal processing circuitry or data transmission, such as a semiconductor device or a input pin on a connector 124.

A first spark gap 20a is interposed between the conductive traces 116 and 118, and connected in parallel to a capacitor 54. The first spark gap 20a is laser ablated to a depth that does not exceed the depth of the dielectric 112. A second spark gap 20b is interposed between the conductive traces 114 and 118, and connected in parallel to a capacitor 54. The second spark gap 20 is laser ablated to a depth that extends through the flex circuit. The second spark gap 20b thus is also vertically disposed, providing alternate ESD protection via distance G that is defined by the thickness G of the dielectric or insulating material 112. Thus, the second spark gap 20b comprises the entire periphery of the conductor edges defining the arcuate voids 22. Capacitors 54 may be optionally connected in parallel with the spark gaps 20a and 20b to provide additional shunt capacitance protection.

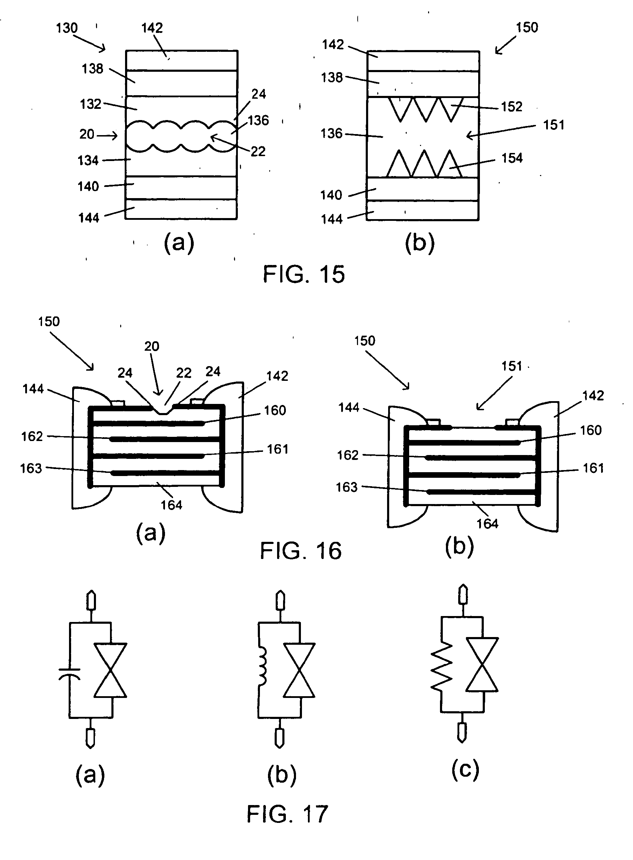

Fig. 15 depicts example embodiments of spark gap devices integrated into surface mount components 130 and 150. Fig. 15(a) depicts a surface mount component 130 having a spark gap device comprising circumferential extensions 24 defining overlapping arcuate voids 22 as described with respect to Figs. 1-4 above. Fig. 15(b) depicts a surface mount component 150 having a spark gap 151 comprising angled extension. The spark gap 151 of Fig. 15(b) may be constructed by a chemical etching process, or by photolithography masking, or other fabrication methods.

Each of the surface mount components 130 and 150 also comprise solder masks 138 and 140 and solder tabs 142 and 144. The spark gap and solder masks 138 and 140 may be distributed on one surface of an insulator 136. The surface mount components 130 and 150 may also comprise a circuit element disposed between the solder tabs 142 and 144 so that the spark gap is connected to the solder tabs 142 and 144 in parallel with the circuit element. The spark gap thus provides bi-directional ESD protection to the electrical element and may further limit over-voltage spikes to a nondestructive level.

The circuit elements may comprise passive circuit components, such as a resistor, inductor or capacitor. Fig. 16 depicts an example embodiment of a spark gap device in a surface mount capacitor 150. The capacitor 150 comprises interlayered electrode plates 160, 161, 162 and 163 and an interposing dielectric 164. The electrode plates 160 and 161 are connected to the solder tab 144, and the electrode plates 162 and 163 are connected to the solder tab 142. A circumferential spark gap device 20 comprising circumferential extensions 24 that define arcuate voids 22 is connected to the solder tabs 142 and 144 in parallel with the electrode plates 160, 161, 162 and 163. Although the novel spark gap device 20 of Figs. 1-6 is implemented in the embodiment of Fig. 16, other spark gap devices comprising a different geometry may also be used, such as the angled spark gap device of Fig. 15(b).

Fig. 17 provides a plurality of circuit representations for various surface mount components having integrated spark gap devices. Figs. 17(a), (b) and (c) depict circuit representations for a surface mount capacitor, inductor, and resistor, respectively. The components of Figs. 17(a), (b) and (c) may facilitate a variety of implementations. For example, the resistor device of Fig. 17 (c) may be implemented as a protected resistor, or may alternatively be implemented as a spark gap having a high bypass resistance. Other two-terminal circuit elements may also be used, and other packing schemes may likewise be used. For example, a two-terminal, multipole filter may be protected by the parallel spark gap device of Fig. 15. Likewise, the parallel spark gap device may also be used to protect other packaging, such as dual in-line (DIP) or small-outline integrated circuit (SOIC) packaging, or be used in conjunction with an IC socket and module.

The capacitance of the spark gap device 20 may also be considered when fabricating the circuit element. For example, if the characteristic capacitance of a circumferential spark gap device 20 is 0.1 pF, and a surface mount component is to provide a capacitance of 10 pF, then the value of the actual capacitor to be connected in parallel with the spark gap device 20 may be adjusted accordingly so that the terminal capacitance is 10 pF.

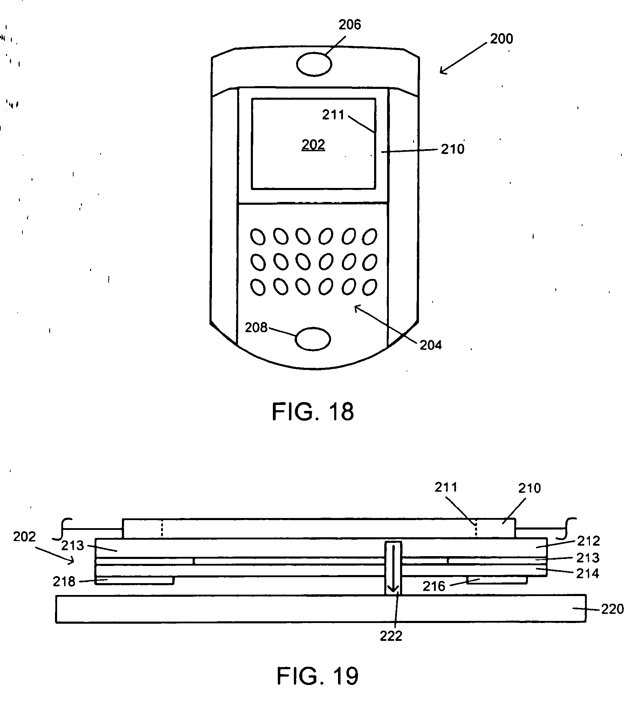

Fig. 18 depicts a top view of a mobile communication device 200. The spark gap device of Figs. 1-4 may be implemented in the mobile communication device 200 to provide ESD protection to ESD-sensitive components. The mobile communication device 200 may have a data communication capability, a voice communication capability, or a combination of data and voice communication capability. The housing of the mobile communication device 200 may include a conductive surface, such as a metal bezel 210 having an interior edge 211. The interior edge 211 defines an opening for viewing a display assembly 202, such as a liquid crystal display (LCD). A keyboard 204, a speaker 206 and a microphone 208 are provided to facilitate voice and data communications.

The mobile device 200 is operable to communicate over a wireless network via a radio frequency link. The metal bezel 210 is an entry point for ESD energy. Typically, however, grounding the metal bezel 210 directly to ground will cause a high capacitive coupling to the mobile device 200 antenna and cause RF communication performance degradation. Accordingly, a spark gap device is implemented to provide ESD protection and minimize capacitive coupling, and reroutes the destructive ESD to a PCB ground.

Fig. 19 depicts a spark gap device 222 for providing ESD protection from a metal surface case component 210 of the mobile communication device 200. A spark gap device 222 provides ESD protection of an LCD assembly 202 by providing a spark gap from the metal bezel 210 to a ground potential on a PCB 220. The LCD assembly 202 may comprise a display window 212, a display gasket 213, an LCD module 214, a LCD driver chip 216, and an LCD I/O connector 218.

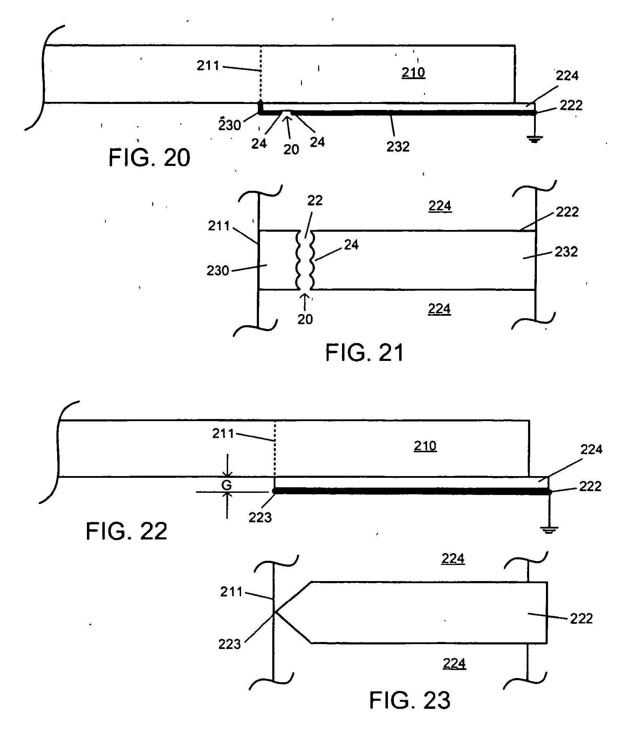

Figs. 20 and 21 depict side and bottom views of one embodiment of a spark gap device for providing ESD protection from a metal surface case component 210 of the mobile communication device 200. In this embodiment, the circumferential spark gap of Figs. 1-6 is used. An insulator 224 separates the spark gap device 222 from the metal bezel 210. A first conductor 230 is connected to the metal bezel 210, proximate to the interior edge 211. A second conductor 232 is connected to a reference ground potential. The first and second conductors 230 and 232 are separated by a spark gap 20 comprising circumferential extensions 24 that define a plurality of overlapping arcuate voids 24.

Figs. 22 and 23 depict side and bottom views of another embodiment of a spark gap device for providing ESD protection from the metal surface case component 210 of the mobile communication device 200. In this embodiment, a triangular shaped spark gap 223 is used. The triangular shaped spark gap 223 is separated from the interior edge 211 of the metal bezel 210 by a gap distance G. An insulator 224 is used to separate the conducting surface of the spark gap device 224 from the metal bezel 210. The other end of the spark gap device 224 is connected to a reference ground potential. In one embodiment, a poron strip is used to realize the spark gap device 224. In another embodiment, two conductors with triangle terminations are used to provide a triangular spark gap. This embodiment is similar to the embodiment of Figs. 18 and 19, except that the spark gap comprises a triangular geometry instead of the circumferential geometry.

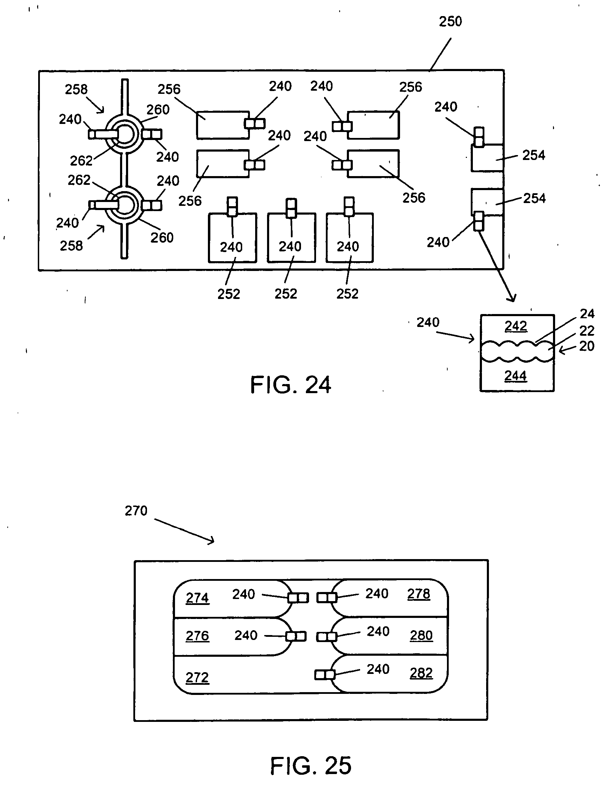

The spark gap devices described herein may be configured to protect other circuitry in the mobile communication device 200. Fig. 24 is an example PCB 250 having integrated circumferential extension spark gap devices 240 for providing ESD protection. Each integrated circumferential spark gap device 240 comprises a first conductor 242 and a second conductor 244 separated by a spark gap 20 comprising a plurality of circumferential extensions 24 that define arcuate voids. The integrated circumferential spark gap devices 240 may be distributed to protect any ESD sensitive circuitry connected to an ESD entry point, such as battery contacts 252, I/O device jacks 254, SIM contacts 256, and/or keypad dome switches 258.

Keypad dome switches 258 comprise a conductive trace 260 and a conductive center pad 262. Each section of the conductive trace 260 defining a keypad area is connected to an integrated circumferential spark gap device 240. Likewise, each conductive center pad 262 is connected to an integrated circumferential spark gap device 240. In the embodiment shown, integrated circumferential spark gap devices 240 connected to the conductive center pad 262 are insulated from the conductive trace 260. ,

The integrated circumferential spark gap devices 240 may also protect removable electronic devices. Fig. 25 is an example subscriber identity module (SIM) card 270 having integrated circumferential extension spark gap devices 240 for providing ESD protection. The integrated circumferential spark gap devices 240 are interposed between a reference potential surface 272 and a power contact 274, a first data contact 276, a clock contact 278, a reset contact 280, and a second data contact.

The embodiments described herein are examples of structures, systems or methods having elements corresponding to the elements of the invention recited in the claims. This written description may enable those of ordinary skill in the art to make and use embodiments having alternative elements that likewise correspond to the elements of the invention recited in the claims. The intended scope of the invention thus includes other structures, systems or methods that do not differ from the literal language of the claims.

**Claims**

1. A method of fabricating a spark gap (20) in a conductor (12) deposited on a first side of a surface material, comprising:

   overlapping laser footprints (10) on the conductor surface (12); and
   laser ablating a void (22) in the conductor (12) in each laser footprint (10) to form first (36) and second conductor elements (38) from the conductor (12) and to form conductive circumferential extensions (24) at the intersections of the laser footprints (10).

2. The method of claim 1, further comprising adjusting the distance (G) between the circumferential extensions (24) by adjusting the amount of overlap in the overlapping laser footprints (10).

3. The method according to one of the claims 1 to 2, wherein the conductive circumferential extensions (24) define a gap spacing (G) of 12 $\mu$m.

4. The method according to one of the claims 1 to 3, further comprising connecting a shunt capacitor (54) to the first conductor.

5. The method of claim 4, wherein connecting a shunt capacitor (54) to first conductor comprises depositing a third conductor on a second side of the surface material so that the surface material is interposed between the first conductor and the third conductor.

6. The method according to one of the claims 1 to 5, further comprising fabricating the spark gap (20) on a surface mount component (150).

7. The method according to one of the claims 1 to 6, wherein overlapping laser footprints (10) on the conductor surface (12) comprises horizontally overlapping laser footprints (10) on the conductor surface (12).

8. The method according to one of the claims 1 to 6, wherein overlapping laser footprints (10) on the conductor surface (12) comprises horizontally and vertically overlapping laser footprints (10) on the conductor surface (12).

9. The method according to one of the claims 7 or 8, wherein the conductive circumferential extensions (24) define a gap spacing (G) greater than a diameter of the overlapping laser footprints (10).

10. An apparatus for providing electrostatic discharge protection comprising a plurality of conductive circumferential extensions (24) defining overlapping arcuate voids (22) between a first conductor surface (36) and a second conductor surface (38),
    **characterized in that**
    the voids (22) are laser ablated voids.

11. The apparatus of claim 10, further comprising a shunt capacitor (54) connected to the first conductor surface (36).

12. The apparatus of claim 11, wherein the shunt capacitor (54) comprises:

    a third conductive surface connected to a ground; and
    a dielectric interposed between the first conductive surface and the third conductive surface.

13. The apparatus according to one of the claims 10 to 12, further comprising a substrate material defining first and second sides and wherein the first conductor surface (36) and the second conductor surface (38) are disposed on the first side of the substrate material.

**14.** The apparatus according to one of the claims 10 to 12, further comprising a substrate material defining first and second sides and wherein the first conductor surface (36) and the second conductor surface (38) are disposed on the first side and second side of the substrate material, respectively.

**15.** The apparatus according to one of the claims 10 to 14, further comprising a surface mount component (150) defining first and second electrical connection points, and wherein the plurality of conductive circumferential extensions (24) are disposed between the first and second electrical connection points on the surface mount component.

**16.** The apparatus of claim 15, wherein the surface mount component (150) comprises a capacitor.

**17.** The apparatus according to one of the claims 10 to 16, wherein the plurality of conductive circumferential extensions (24) comprise flex circuit conductors.

**18.** The apparatus according to one of the claims 10 to 17, wherein the plurality of conductive circumferential extensions (24) comprise printed circuit board conductors.

**19.** An apparatus of claim 10, wherein
the first conductor surface comprises a first conductive trace (36) that includes a first plurality of conductive circumferential extensions (24); and
the second conductor surface comprises a second conductive trace (38) that includes a second plurality of conductive circumferential extensions (24);
wherein the first and second plurality of circumferential extensions (24) define the overlapping arcuate voids (22) between the first (36) and second (38) conductive traces, and
wherein the second plurality of conductive circumferential extensions (24) is in opposing disposition to the first plurality of circumferential extensions (24), with each extension (24) of the second plurality of conductive circumferential extensions (24) being in opposing disposition to one extension (24) of the first plurality of conductive circumferential extensions (24) and the distance between the tips of the first plurality of conductive circumferential extensions (24) and the tips of the second plurality of conductive circumferential extensions (24) being the spark gap distance of the apparatus.

**20.** The apparatus of claim 19, wherein the first (36) and second (38) conductive traces are integrated into a thin film interconnect.

**21.** A mobile communication device (200), comprising:

a housing comprising at least one outer conductive housing surface (210);
an electrical subsystem comprising a ground; and
an apparatus according to claim 10, the apparatus being a spark gap electrode (222) interposed between the outer conductive surface (210) and the ground (220), with the first conductor surface (230) being connected to the outer conductive surface (210) and the second conductor surface (232) being connected to the ground (220).

**22.** The mobile communication (200) device of claim 21, further comprising:

a keypad, the keypad comprising a plurality of dome switches (258), each dome switch (258) corresponding to a key; and
an apparatus according to claim 10, the apparatus being a spark gap electrode (240) interposed between one or more dome switches (258) and ground, with the first conductor surface (242) being connected to the one or more dome switches (258) and the second conductor surface (244) being connected to the ground.

**Patentansprüche**

**1.** Verfahren zur Herstellung einer Funkenstrecke (20) in einem Leiter (12), der auf einer ersten Seite eines Oberflächenmaterials angebracht ist, wobei das Verfahren aufweist:

Überlappen von Laser-Abdrücken (10) auf der Leiteroberfläche (12); und
Laser-Abtragen einer Lücke (22) in dem Leiter (12) in jedem Laser-Abdruck (10), um erste (36) und zweite (38) Leiterelemente aus dem Leiter (12) zu bilden und um leitende Umfangsvorsprünge (24) an den Schnittstellen der Laser-Abdrücken (10) zu bilden.

**2.** Verfahren gemäß Anspruch 1, das weiter aufweist ein Anpassen des Abstands (G) zwischen dem Umfangsvorsprung durch Anpassen des Ausmaßes der Überlappung in den überlappenden Laser-Abdrücken (10).

**3.** Verfahren gemäß einem der Ansprüche 1 bis 2, wobei die leitenden Umfangsvorsprünge (24) einen Abstand (G) von 12 μm definieren.

**4.** Verfahren gemäß einem der Ansprüche 1 bis 3, das weiter ein Verbinden eines Shuntkondensators (54) mit dem ersten Leiter aufweist.

**5.** Verfahren gemäß Anspruch 4, wobei das Verbinden eines Shuntkondensators (54) mit dem ersten Leiter ein Aufbringen eines dritten Leiters auf einer zweiten Seite des Oberflächenmaterials aufweist, so dass das Oberflächenmaterial zwischen dem ersten Leiter und dem dritten Leiter eingefügt ist.

6. Verfahren gemäß einem der Ansprüche 1 bis 5, das weiter aufweist ein Herstellen der Funkenstrecke (20) auf einer an der Oberfläche angebrachten Komponente (150).

7. Verfahren gemäß einem der Ansprüche 1 bis 6, wobei ein Überlappen der Laser-Abdrücken (10) auf der Leiteroberfläche (12) ein horizontales Überlappen der Laser-Abdrücken (10) auf der Leiteroberfläche (12) aufweist.

8. Verfahren gemäß einem der Ansprüche 1 bis 6, wobei ein Überlappen der Laser-Abdrücken (10) auf der Leiteroberfläche (12) ein horizontales und vertikales Überlappen der Laser-Abdrücken (10) auf der Leiteroberfläche (12) aufweist.

9. Verfahren gemäß einem der Ansprüche 7 oder 8, wobei die leitenden Umfangsvorsprünge (24) einen Abstand (G) definieren, der größer als ein Durchmesser der überlappenden Laser-Abdrücken (10) ist.

10. Vorrichtung zum Vorsehen eines elektrostatischen Entladungsschutzes, der eine Vielzahl von leitenden Umfangsvorsprüngen (24) aufweist, die überlappende kreisförmige Lücken (22) zwischen einer ersten Leiteroberfläche (36) und einer zweiten Leiteroberfläche (38) definieren,
**dadurch gekennzeichnet, dass**
die Lücken (22) Laser-abgetragene Lücken sind.

11. Vorrichtung gemäß Anspruch 10, die weiter aufweist einen Shuntkondensator (54), der mit der ersten Leiteroberfläche (36) verbunden ist.

12. Verfahren gemäß Anspruch 11, wobei der Shuntkondensator (54) aufweist:

eine dritte leitende Oberfläche, die mit einer Masse verbunden ist; und
ein Dielektrikum, das zwischen der ersten leitenden Oberfläche und der dritten leitenden Oberfläche eingefügt ist.

13. Vorrichtung gemäß einem der Ansprüche 10 bis 12, die weiter aufweist ein Substratmaterial, das erste und zweite Seiten definiert, und wobei die erste Leiteroberfläche (36) und die zweite Leiteroberfläche (38) auf der ersten Seite des Substratmaterials angeordnet sind.

14. Vorrichtung gemäß einem der Ansprüche 10 bis 12, die weiter aufweist ein Substratmaterial, das erste und zweite Seiten definiert, und wobei die erste Leiteroberfläche (36) und die zweite Leiteroberfläche (38) jeweils auf der ersten Seite und der zweiten Seite des Substratmaterials angeordnet sind.

15. Vorrichtung gemäß einem der Ansprüche 10 bis 14, die weiter aufweist eine an der Oberfläche angebrachte Komponente (150), die erste und zweite elektrische Verbindungspunkte definiert, und wobei die Vielzahl der leitenden Umfangsvorsprünge (24) zwischen den ersten und zweiten elektrischen Verbindungspunkten auf der an der Oberfläche angebrachten Komponente (150) angeordnet sind.

16. Vorrichtung gemäß Anspruch 15, wobei die an der Oberfläche angebrachte Komponente (150) einen Kondensator aufweist.

17. Vorrichtung gemäß einem der Ansprüche 10 bis 16, wobei die Vielzahl der leitenden Umfangsvorsprünge (24) Flexschaltungsleiter aufweisen.

18. Vorrichtung gemäß einem der Ansprüche 10 bis 17, wobei die Vielzahl der leitenden Umfangsvorsprünge (24) Leiterplattenleiter aufweisen.

19. Vorrichtung gemäß Anspruch 10, wobei
die erste leitende Oberfläche eine erste leitende Bahn (36) aufweist, die eine erste Vielzahl von leitenden Umfangsvorsprüngen (24) umfasst; und
die zweite leitende Oberfläche eine zweite leitende Bahn (38) aufweist, die eine zweite Vielzahl von leitenden Umfangsvorsprüngen (24) umfasst;
wobei die erste und zweite Vielzahl der Umfangsvorsprünge (24) die überlappenden kreisförmigen Lücken (22) zwischen den ersten (36) und zweiten (38) leitenden Bahnen definieren, und
wobei die zweite Vielzahl der leitenden Umfangsvorsprünge (24) in entgegengesetzter Anordnung zu der ersten Vielzahl der leitenden Umfangsvorsprünge (24) ist, wobei jeder Vorsprung (24) der zweiten Vielzahl der leitenden Umfangsvorsprünge (24) in entgegengesetzter Anordnung zu einem Vorsprung (24) der ersten Vielzahl der leitenden Umfangsvorsprünge (24) ist und der Abstand zwischen den Spitzen der ersten Vielzahl der leitenden Umfangsvorsprünge (24) und den Spitzen der zweiten Vielzahl der leitenden Umfangsvorsprünge (24) der Funkenstreckenabstand der Vorrichtung ist.

20. Vorrichtung gemäß Anspruch 19, wobei die ersten (36) und zweiten (38) leitenden Bahnen in eine Dünnfilmverbindung integriert sind.

21. Mobile Kommunikationsvorrichtung (200), die aufweist:

ein Gehäuse, das zumindest eine äußere leitende Gehäuseoberfläche (210) aufweist;
ein elektrisches Teilsystem, das eine Masse aufweist; und
eine Vorrichtung gemäß Anspruch 10, wobei die Vorrichtung eine Funkenstreckenelektrode (222) ist, die zwischen der äußeren leitenden Oberfläche (210) und der Masse (220) eingefügt ist, wobei die erste Leiteroberfläche (230) mit der äußeren leitenden Oberfläche (210) und die zweite Leiteroberfläche (232) mit der Masse (220) verbunden ist.

22. Die mobile Kommunikationsvorrichtung (200) gemäß Anspruch 21, die weiter aufweist :

eine Tastatur, wobei die Tastatur eine Vielzahl von kuppelförmigen Schaltern (258) aufweist, wobei jeder kuppelförmige Schalter (258) einer Taste entspricht; und
eine Vorrichtung gemäß Anspruch 10, wobei die Vorrichtung eine Funkenstreckenelektrode (240) ist, die zwischen einem oder mehreren kuppelförmigen Schalter(n) (258) und der Masse eingefügt ist, wobei die erste Leiteroberfläche (242) mit einem oder mehreren kuppelförmigen Schalter(n) (258) verbunden ist und die zweite Leiteroberfläche (244) mit der Masse verbunden ist.

## Revendications

1. Procédé destiné à la fabrication d'un éclateur (20) dans un conducteur (12) déposé sur un premier côté d'un matériau de surface, comprenant :

le dépôt d'empreintes laser se chevauchant (10) sur la surface du conducteur (12) ; et
la formation par ablation laser d'un vide (22) dans le conducteur (12) au niveau de chaque empreinte laser (10) de façon à former les premier (36) et second (38) éléments de conducteur à partir du conducteur (12) et à former des prolongements circonférentiels conducteurs (24) aux intersections des empreintes laser (10).

2. Procédé selon la revendication 1, comprenant en outre le réglage de la distance (G) entre les prolongements circonférentiels conducteurs (24) par ajustement de la valeur du chevauchement des empreintes laser se chevauchant (10).

3. Procédé selon l'une quelconque des revendications 1 ou 2, dans lequel les prolongements circonférentiels conducteurs (24) définissent un espace interstitiel (G) de 12 $\mu$m.

4. Procédé selon l'une quelconque des revendications 1 à 3, comportant en outre la connexion d'un condensateur shunt (54) au premier conducteur.

5. Procédé selon la revendication 4, dans lequel la connexion d'un condensateur shunt (54) comprend le dépôt d'un troisième conducteur sur un second côté du matériau de surface de telle sorte que le matériau de surface se trouve intercalé entre le premier conducteur et le troisième conducteur.

6. Procédé selon l'une quelconque des revendications 1 à 5, comprenant en outre la fabrication de l'éclateur (20) sur un composant à montage en surface (150).

7. Procédé selon l'une quelconque des revendications 1 à 6, dans lequel les empreintes laser se chevauchant (10) sur la surface de conducteur (12) comprennent des empreintes laser se chevauchant (10) horizontalement sur la surface de conducteur (12).

8. Procédé selon l'une quelconque des revendications 1 à 6, dans lequel les empreintes laser se chevauchant (10) sur la surface de conducteur (12) comprennent des empreintes laser se chevauchant (10) horizontalement et verticalement sur la surface de conducteur (12).

9. Procédé selon l'une quelconque des revendications 7 ou 8, dans lequel les prolongements circonférentiels conducteurs (24) définissent un espace intersticie (G) plus large qu'un diamètre des empreintes laser se chevauchant (10).

10. Appareil destiné à apporter une protection contre les décharges électrostatiques comprenant une pluralité de prolongements circonférentiels conducteurs (24) délimitant des espaces vides en arc de cercle se chevauchant (22) entre une première surface de conducteur (36) et une seconde surface de conducteur (38),
**caractérisé en ce que**
les espaces vides (22) sont formés par ablation laser.

11. Appareil selon la revendication 10, comprenant en outre une condensateur shunt (54) connecté à la première surface de conducteur (36).

12. Appareil selon la revendication 11, dans lequel le condensateur shunt (54) comprend :

une troisième surface conductrice reliée à une masse ; et
un diélectrique intercalé entre la première surface conductrice et la troisième surface conductrice.

**13.** Appareil selon l'une quelconque des revendications 10 à 12, comprenant en outre un matériau de substrat définissant un premier et un second côté et dans lequel la première surface de conducteur (36) et la seconde surface de conducteur (38) sont disposées sur le premier côté du matériau de substrat.

**14.** Appareil selon l'une quelconque des revendications 10 à 12, comprenant en outre un matériau de substrat définissant un premier et un second côté et dans lequel la première surface de conducteur (36) et la seconde surface de conducteur (38) sont disposées respectivement sur le premier côté et sur le second côté du matériau de substrat.

**15.** Appareil selon l'une quelconque des revendications 10 à 14, comprenant en outre un composant à montage en surface (150) définissant un premier et un second point de connexion électrique, et dans lequel la pluralité de prolongements circonférentiels conducteurs (24) est disposée entre les premier et second points de connexion électrique sur le composant à montage en surface.

**16.** Appareil selon la revendication 15, dans lequel le composant à montage en surface (150) comprend un condensateur.

**17.** Appareil selon l'une quelconque des revendications 10 à 16, dans lequel la pluralité de prolongements circonférentiels conducteurs (24) comprend des conducteurs de circuit souple.

**18.** Appareil selon l'une quelconque des revendications 10 à 17, dans lequel la pluralité de prolongements circonférentiels conducteurs (24) comprend des conducteurs de carte de circuit imprimé.

**19.** Appareil selon la revendication 10, dans lequel :

la première surface de conducteur comprend une première piste conductrice (36) qui comprend une première pluralité de prolongements circonférentiels conducteurs (24) ; et
la seconde surface de conducteur comprend une seconde piste conductrice (38) qui comprend une seconde pluralité de prolongements circonférentiels conducteurs (24) ;

dans lequel les première et seconde pluralités de prolongements circonférentiels conducteurs (24) délimitent des cavités en arc de cercle se chevauchant (22) entre les première (36) et seconde (38) pistes conductrices, et
dans lequel la seconde pluralité de prolongements circonférentiels conducteurs (24) est dans une position opposée par rapport à celle de la première pluralité de prolongements circonférentiels conducteurs (24), avec chaque prolongement (24) de la seconde pluralité de prolongements circonférentiels conducteurs (24) étant en position opposée par rapport à celle d'un prolongement (24) de la première pluralité de prolongements circonférentiels conducteurs (24) et la distance entre les extrémités de la première pluralité de prolongements circonférentiels conducteurs (24) et les extrémités de la seconde pluralité de prolongements circonférentiels conducteurs (24) étant l'écartement de l'éclateur de l'appareil.

**20.** Appareil selon la revendication 19, dans lequel les première (36) et seconde (38) pistes conductrices sont intégrées dans une interconnexion de film mince.

**21.** Dispositif de télécommunications mobiles (200), comprenant :

un boîtier comprenant au moins une surface de boîtier extérieure conductrice (210) ;
un sous-système électrique comprenant une masse ; et
un appareil selon la revendication 10, l'appareil étant une électrode d'éclateur (222) interposée entre la surface conductrice extérieure (210) et la masse (220), avec la première surface de conducteur (230), étant connectée à la surface conductrice extérieure (210) et la seconde surface de conducteur (232) étant connectée à la masse (220).

**22.** Dispositif de télécommunications mobiles (200) selon la revendication 21, comprenant en outre :

un clavier, le clavier comprenant une pluralité de commutateurs de type dôme (258), chaque commutateur de type dôme (258) correspondant à une touche ; et
un appareil selon la revendication 10, l'appareil étant une électrode d'éclateur (240) interposée entre un ou plusieurs commutateurs type dôme (258) et la masse, avec la première surface de conducteur (242) étant connectée à un ou plusieurs connecteurs type dôme (258) et la seconde surface de conducteur (244) étant connectée à la masse.

14    12    13

10    24    10    14    10

24

24

20 - - - - - →

22    22    22  G    SPARK
GAP

24

24    24

D

24

16    15

LASER
FOOTPRINT

## FIG. 1

```
INPUT DESIGN DATA INTO LASER ABLATION    31    30
DEVICE FOR CONDUCTOR REMOVAL
```

```
OVERLAP LASER FOOTPRINTS ON CONDUCTOR    32
SURFACE
```

```
LASER ABLATE VOID AT EACH LASER    33
FOOTPRINT
```

```
EVALUATE LASER ABLATED SPARK GAP    34
```

## FIG. 2

FIG. 3

FIG. 4

FIG. 5

FIG. 6

FIG. 7

FIG. 8

FIG. 9

FIG. 10

FIG. 11

FIG. 12

FIG. 13

110

116

112

20a

54

112

118

112

20b

54

112

124

114

FIG. 14

FIG. 15

FIG. 16

FIG. 17

206

200

211

202

210

208

204

FIG. 18

211    210

202

213

218

213
214
216

222

220

FIG. 19

**FIG. 20**

**FIG. 21**

**FIG. 22**

**FIG. 23**

250

258    256    240    240    256    240

240    260

262    240

262    240    240    254

240    240    254

262    240

258    260    240

256    256

240    240    240    240

252    252    252

240    242    24
22
20
244

**FIG. 24**

270

274    240    240    278

276    240    240    280

272    240    282

**FIG. 25**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20030075532 A1
- EP 0610898 A1

**Non-patent literature cited in the description**

- **P. GILMORE et al.** A Componentless, Electrostatic Discharge Technique. *Motorola Technical Developments, Motorola Inc., Schaumburg, Illinois, US,* 01 October 1993, vol. 20, 135